(19) Europäisches Patentamt
European Patent Office
Office européen des brevets

(11) **EP 2 477 039 A1**

(12) **EUROPEAN PATENT APPLICATION**
published in accordance with Art. 153(4) EPC

(43) Date of publication:
**18.07.2012 Bulletin 2012/29**

(21) Application number: **10815097.0**

(22) Date of filing: **20.07.2010**

(51) Int Cl.:
*G01R 1/067* (2006.01)      *G01R 31/26* (2006.01)
*H01B 11/18* (2006.01)      *H01B 13/016* (2006.01)

(86) International application number:
**PCT/JP2010/004639**

(87) International publication number:
**WO 2011/030494 (17.03.2011 Gazette 2011/11)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **09.09.2009 JP 2009207978**

(71) Applicant: **Mitsubishi Cable Industries, Ltd.**
**Chiyoda-ku**
**Tokyo 100-8303 (JP)**

(72) Inventors:
• **KOBAYASHI, Yuuji**
**Fukui Prefecture 910-3138 (JP)**

• **YAMAMOTO, Takumi**
**Fukui Prefecture 910-3138 (JP)**
• **KANEKO, Takashi**
**Hyogo Prefecture 660-0856 (JP)**

(74) Representative: **TER MEER - STEINMEISTER & PARTNER GbR**
**Patentanwälte**
**Mauerkircherstrasse 45**
**81679 München (DE)**

(54) **COAXIAL PROBE PIN, COAXIAL CABLE, AND METHOD FOR MANUFACTURINGTHE COAXIAL PROBE PIN**

(57) Disclosed is a coaxial probe pin, comprising an internal conductor, an insulator circumferentially provided around the internal conductor, an adhesive layer provided in an outer periphery of the insulator, and an external conductor including a plurality of wire rods and securely fixed by the adhesive layer to the outer periphery of the insulator. The adhesive layer is formed by winding an adhesive tape made of a material that can melt at a temperature lower than the melting temperature of the insulator around the outer periphery of the insulator and heating the adhesive tape to be integrally melted.

FIG. 1

EP 2 477 039 A1

**Description**

FIELD OF THE INVENTION

The present invention relates to a coaxial probe pin and a coaxial cable used to test electrical characteristics of such devices as IC chips and board-mounted electric circuits, and a method for manufacturing the coaxial probe pin.

BACKGROUND OF THE INVENTION

To keep abreast of increasingly higher processing speeds in semiconductor IC devices, there is a strong need for a probe pin of coaxial type (coaxial probe pin) having a shielded structure and a coaxial cable constituting the coaxial probe pin, so that test signals at higher frequencies can be transmitted (see the Patent Document 1).

Describing a basic structure of the coaxial probe pin or the coaxial cable, an insulator is circumferentially provided around an internal conductor serving as an electrically conductive needle, and an external conductor including a plurality of wire rods is provided in an outer periphery of the insulator. Conventionally, a sheath member is further provided in an outer periphery of the external conductor.

PRIOR ART DOCUMENT

PATENT DOCUMENT

Patent Document 1:    Japanese Patent Application Publication No. 2002-257849

SUMMARY OF THE INVENTION

PROBLEM TO BE SOLVED BY THE INVENTION

To be subjected to, for example, a terminal treatment, the coaxial probe pin is formed in a structure where the external conductor is protruding stepwise from the sheath member provided to sheath the outer periphery of the external conductor and exposed on both end sides thereof.

The external conductor thus exposed is easily deformed or disentwined during handling and may create problems detrimental to further handling later on. This conventional disadvantage may happen likewise in the coaxial cable.

The present invention provides a technically advantageous structure where exposed bare end portions of an external conductor are not deformed or disentwined.

MEANS FOR SOLVING THE PROBLEM

The present invention relates to a coaxial probe pin. The coaxial probe pin according to the present invention comprises:

an internal conductor serving as an electrically conductive needle;
an insulator circumferentially provided around the internal conductor;
an adhesive layer provided in an outer periphery of the insulator; and
an external conductor including a plurality of wire rods and securely fixed by the adhesive layer to the outer periphery of the insulator.

According to the coaxial probe pin thus structurally characterized, the external conductor is securely fixed to a surface of the outer periphery of the insulator. More particularly, bare end portions of the external conductor are securely fixed by the adhesive layer to the surface of the outer periphery of the insulator on both end sides of the coaxial probe pin. This technical feature can avoid the risk of deforming or disentwining the end portions of the external conductor.

In the coaxial probe pin thus structurally characterized, an adhesive material constituting the adhesive layer may be provided in the form of a tape to be wound around the outer periphery of the insulator, or may be provided in the form of a paste to be spread on the surface of the outer periphery of the insulator.

In the coaxial probe pin thus structurally characterized, the adhesive layer is desirably made of a material that can melt at a temperature lower than a melting temperature of the insulator.

The material of the adhesive layer is provided in the outer periphery of the insulator and the external conductor is further provided in the outer periphery of the adhesive layer. The material of the adhesive layer is then melted so that the external conductor is thereby securely fixed to the surface of the outer periphery of the insulator. This process can avoid the risk of deforming the insulator or deteriorating properties of the insulator.

The present invention relates to a coaxial cable. The coaxial cable according to the present invention comprises:

an internal conductor;
an insulator circumferentially provided around the internal conductor;
an adhesive layer provided in an outer periphery of the insulator; and
an external conductor including a plurality of wire rods and securely fixed by the adhesive layer to the outer periphery of the insulator.

According to the coaxial cable thus structurally characterized, bare end portions of the external conductor, if exposed on both end sides thereof, are not deformed or disentwined.

The present invention relates to a coaxial probe pin. The coaxial probe pin according to the present invention comprises an insulator having therein an internal conductor serving as an electrically conductive needle, wherein an adhesive tape made of a material that can melt at a temperature lower than a melting temperature of the insulator is wound around an outer periphery of the insulator, an external conductor including a plurality of wire rods is wound around an outer periphery of the wound adhesive tape, a heat treatment is performed to a structural body including the external conductor, the adhesive tape, and the insulator at a temperature lower than the melting temperature of the insulator at which the adhesive tape can melt so that the adhesive tape is integrally melted to form an adhesive layer, and the external conductor is securely adhered by the adhesive layer to the outer periphery of the insulator.

The external conductor is securely fixed by the adhesive layer formed from the melted adhesive tape to a surface of the outer periphery of the insulator, and bare end portions of the external conductor exposed on both end sides of the coaxial probe pin are securely fixed by the adhesive layer to the surface of the outer periphery of the insulator. Therefore, the end portions of the external conductor are not deformed or disentwined.

The heat treatment, which is performed to melt the adhesive tape at a temperature lower than the melting temperature of the insulator, does not involve the risk of deforming the insulator or deteriorating properties of the insulator.

Because the adhesive tape is wound around the outer periphery of the insulator and integrally melted to form the adhesive layer, thicknesses in different parts of the adhesive layer can be easily controlled. The adhesive layer thus formed has no thickness variability unlike an adhesive layer obtained by applying an adhesive, thereby facilitating the winding work of the external conductor.

The present invention relates to a coaxial probe pin manufacturing method. The coaxial probe pin manufacturing method according to the present invention comprises:

preparing an insulator having therein an internal conductor serving as an electrically conductive needle;
winding an adhesive tape made of a material that can melt at a temperature lower than a melting temperature of the insulator around an outer periphery of the insulator;
winding an external conductor including a plurality of wire rods around an outer periphery of the wound adhesive tape; and
circumferentially locating an external tape layer around the wound external conductor, a tape made of a material that can melt at a temperature equal to a melting temperature of the adhesive tape being wound around the external tape layer, wherein
a heat treatment is performed to a structural body including the external taper layer, the external conductor, the adhesive tape, and the insulator at a temperature lower than the melting temperature of the insulator at which the adhesive tape and the external tape layer can both melt so that the adhesive tape is integrally melted to form an adhesive layer,
the external conductor is securely adhered by the adhesive layer to the outer periphery of the insulator, and
the external tape layer is melted to be integral with an outer periphery of the external conductor.

The coaxial probe pin manufacturing method can produce the coaxial probe pin wherein the exposed external conductor is not deformed or disentwined. Further, the method can securely fix the external conductor to the insulator and provide the coating by integrally melting the external tape layer at once through one heat treatment to the structural body including the external tape layer, external conductor, adhesive tape, and insulator. The method thus technically advantageous can simplify the working steps.

The manufacturing method using the adhesive tape can provide the adhesive layer achieving a thickness uniformity in any parts thereof. As a result, the adhesive layer has no thickness variability, thereby stabilizing a degree of adhesion between the external conductor and the insulator. Because the heat treatment to melt the adhesive tape is performed at a temperature lower than the melting temperature of the insulator, possible deformation of the insulator and deterioration of properties of the insulator can be prevented from happening.

When the adhesive tape is wound, the coaxial probe pin manufacturing method preferably employs so that the wound adhesive tape has a surface with no rises; a single-lap winding in which the adhesive tape is wound around the outer periphery of the insulator in a manner that wound parts are adjacent to one another, or a 1/2-lap winding in which the adhesive tape is wound around the outer periphery of the insulator in a manner that wound parts overlap one another in substantially half a width dimension thereof.

According to the manufacturing method wherein the surface of the wound adhesive tape has no irregularity, a winding failure, which is likely to occur in such an event that the wire rods of the external conductor wound around the outer periphery of the adhesive tape run on any raised parts of the adhesive tape, is prevented from happening.

According to the coaxial probe pin manufacturing method, the adhesive tape and the external conductor are preferably wound in helical directions reverse to each other. In the case where the adhesive tape and the external conductor are wound in the same helical direction, any force acting on one of the adhesive tape and the external conductor in a direction where the winding is loosened may also act on the other such that the winding is similarly loosened. When the described method is employed, however, the force acting on one of them in a direction where the winding is loosened does not act on the other such that the winding is loosened. On the contrary, a loosening behavior of the winding in one of them is arrested by contacts made with the other. This counteraction eventually prevents the adhesive tape and the external conductor both from loosening.

According to the coaxial probe pin manufacturing method, when the adhesive tape and the external conductor are wound in helical directions reverse to each other, an intersection angle $\alpha$ at which the winding direction of the adhesive tape and the winding direction of the external conductor intersect with each other is preferably set to $80° < \alpha < 100°$.

When the intersection angle is thus set, the winding directions of the adhesive tape and the external conductor are substantially orthogonal to each other. As a result of this, any force acting on one of the adhesive tape and the external conductor in its loosening direction never participates in an action on the other in its loosening direction. It is ensured by the contacts thus made between the adhesive tape and the external conductor that neither of them is possibly loosened.

EFFECT OF THE INVENTION

The present invention can avoid the conventional risk of deforming or disentwining the bare external conductor exposed on both end sides of the coaxial probe pin or the coaxial cable, thereby preventing the occurrence of any handling problems later on.

BRIEF DESCRIPTION OF THE DRAWINGS

Fig. 1 is a side view of a coaxial probe pin cut in cross section according to an exemplary embodiment 1 of the present invention.
Fig. 2 is a cross sectional view of the coaxial probe pin according to the exemplary embodiment 1.
Fig. 3 is a cross sectional view of a coaxial probe pin according to an exemplary embodiment 2 of the present invention.

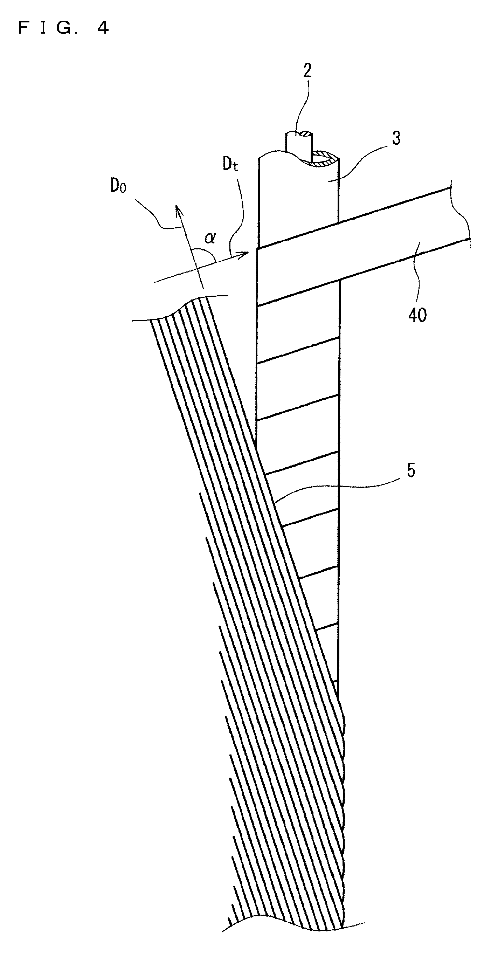

Fig. 4 is an illustration of a coaxial probe pin manufacturing process according to the present invention, wherein an adhesive tape and an external conductor are wound around an outer periphery of an insulator.

EXEMPLARY EMBODIMENTS FOR CARRYING OUT THE INVENTION

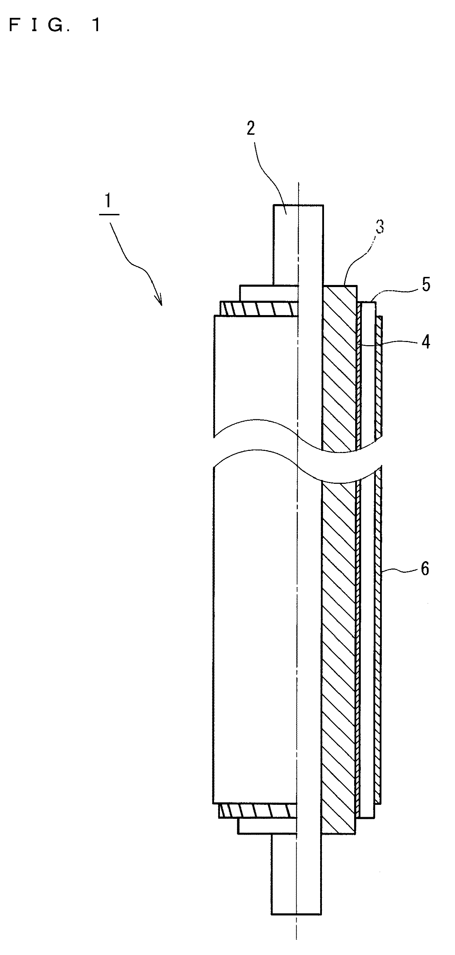

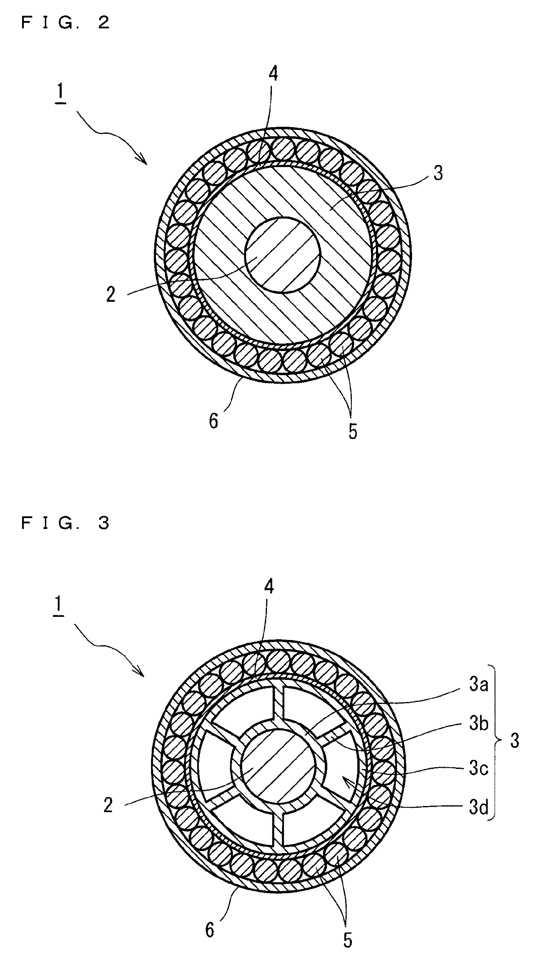

Hereinafter, an exemplary embodiment 1 of the present invention is described referring to the accompanied drawings. As illustrated in Figs. 1 and 2, a coaxial probe pin 1 according to the present exemplary embodiment includes an internal conductor 2 serving as an electrically conductive needle, an insulator where the internal conductor 2 is inserted through at the center, an adhesive layer 4 provided in an outer periphery of the insulator 3, an external conductor 5 securely fixed by the adhesive layer 4 to the outer periphery of the insulator 3, and a sheath member 6 provided to sheath an outer periphery of the external conductor 5.

The overall shape of the coaxial probe pin 1 is an extremely thin linear shape having an axial length equal to approximately 20 mm and an outer diameter equal to approximately 0.3 mm, wherein the external conductor 5 is protruding stepwise from the sheath member 6 and exposed on both end sides thereof. The internal conductor 2 is formed from a tungsten solid wire whose diameter is approximately 0.1 mm.

The insulator 3 is produced by molding an insulating resin material such as PFA (tetrafluoroethylene-perfluoroalkyl vinylether copolymer). In the insulator 3, the internal conductor 2 is inserted therethrough at the center.

The adhesive layer 4 is made of a material having a melting point lower than the melting point of the insulator 3, in other words, a material that can melt at a temperature lower than the melting temperature of the insulator 3. Though an adhesive material in the form of a paste may be applied to form the adhesive layer 4, the present exemplary embodiment is structurally characterized in that a resin-made tape (adhesive tape) that can melt at a temperature lower than the melting temperature of the insulator 3 is wound around the outer periphery of the insulator 3, and the wound adhesive tape is heated to be integrally melted to form the adhesive layer 4, which will be described later in further detail.

The adhesive tape is preferably a polyester tape made of, for example, polyethylene naphthalate (PEN, dielectric constant 2.8@1 KHz) or polyethylene terephthalate (PET, dielectric constant 3.2@1 KHz) because these materials have the low dielectric constants within the range from approximately 2.5 to 3.5 and are suitable materials to easily obtain a uniform thickness.

Other than the tape, a thermoplastic adhesive, for example, "STAYSTIK (product name)" supplied by CSPM, US (dielectric constant 3.8 - 5.6) may be processed into a pasty material and sprayed to form the adhesive layer 4.

The external conductor 5 is formed by helically winding more than 20 thin copper alloy wires plated with tin and having the diameter of 0.03 mm. The sheath member 6 is made of a material having a melting point substantially equal to the melting point of the material of the adhesive layer 4, in other words, a material that can melt at a temperature substantially equal to the melting temperature of the material of the adhesive layer 4. A specific example of the material constituting the sheath member 6 is a PEP (polyethylene terephthalate) tape.

The insulator 3 according to the exemplary embodiment 1 is a solid-core insulator, however, a hollow insulator may be used as described in an exemplary embodiment 2 illustrated in Fig. 3. The insulator 3 has an inner insulating layer 3 a having the internal conductor 2 inserted therethrough, a plurality of ribs 3b, 3b, ... (six ribs according to the present exemplary embodiment) radially extending from the inner insulating layer 3a, and an outer insulating layer 3c connected to outer ends of the ribs 3b, wherein intervals 3d penetrating though in a length direction of the internal conductor 2 are formed between the ribs 3b, 3b circumferentially adjacent to each other..

Next, a method for manufacturing the coaxial probe pin 1 thus structurally characterized is described. First, the insulator 3 is formed circumferentially around the internal conductor 2 to prepare the insulator 3 having therein the internal conductor 2.

To provide the adhesive layer 4 in the outer periphery of the insulator 3, an adhesive tape 40, which is the material tape of the adhesive layer 4, is helically wound around the outer periphery of the insulator 3 as illustrated in Fig. 3.

The adhesive tape 40 is made of a material having a melting point lower than the melting point of the insulator 3 that can melt at a temperature lower than the melting temperature of the insulator 3. There are two ways of winding the adhesive tape 40 so that the wound adhesive tape has a surface with no rises; a single-lap winding in which wound parts are adjacent to one another with very little interval therebetween as illustrated in the drawing, and a 1/2-lap winding in which wound parts overlap one another in a given width dimension thereof.

Then, the external conductor 5 is helically wound around the outer periphery of the helically wound adhesive tape 40 in a helical direction reverse to that of the adhesive tape 40 so that neither of the winding of the adhesive tape 40 nor the winding of the external conductor 5 is loosened.

When the external conductor 5 and the adhesive tape 40 are thus wound, an intersection angle $\alpha$ at which a winding direction Dt of the adhesive tape 40 and a winding direction Do of the external conductor 5 intersect with each other is set to;

$$80° < \alpha < 100° \qquad \dots 1)$$

When the winding direction of the adhesive tape 40 and the winding direction of the external conductor 5 intersect with each other at a perpendicular angle or at angles near the perpendicular angle, the winding of the adhesive tape 40 and the winding of the external conductor 5 both remain unloosened.

The sheath member 6, which is an external tape layer formed by winding a tape, is provided around the wound external conductor 5. A structural body including the sheath member 6, external conductor 5, adhesive tape 40, insulator 3, and internal conductor 2 is transported into a heating furnace to perform a heat treatment to the structural body at a temperature lower than the melting temperature of the insulator 3 at which the adhesive tape 40 and the material tape of the sheath member 6 both can melt (more specifically, 100°C - 150°C).

The heat treatment integrally melts the material tape of the sheath member 6 in the outer periphery of the external conductor 5 to tightly coat the entire circumference of the external conductor 5.

On the inner side of the external conductor 5, the adhesive tape 40 is integrally melted to form the adhesive layer 4, and the resulting adhesive layer 4 securely fixes the external conductor 5 to the surface of the outer periphery of the insulator 3. Accordingly, bare end portions of the external conductor 5, which are protruding from the sheath member 6 (melted and then solidified external tape layer), are not deformed or disentwined.

Because the heat treatment is performed at a temperature lower than the melting temperature of the insulator 3, there is no risk of deforming or melting the insulator 3.

According to another exemplary embodiment of the present invention, a resin-made tape having an adhesive applied to a surface thereof is wound around the outer periphery of the insulator 3 in a helical manner or along a length direction thereof to form the adhesive layer 4.

INDUSTRIAL APPLICABILITY

The present invention provides an advantageous and innovative technology for a coaxial probe pin and a coaxial cable used to test electrical characteristics of such devices as IC chips and board-mounted electric circuits, and a method for manufacturing the coaxial probe pin.

DESCRIPTION OF REFERENCE SYMBOLS

1    coaxial probe pin
2    internal conductor
3    insulator
4    adhesive layer
40   adhesive tape
5    external conductor
6    sheath member

**Claims**

1. A coaxial probe pin, comprising:

   an internal conductor serving as an electrically conductive needle;
   an insulator circumferentially provided around the internal conductor;
   an adhesive layer provided in an outer periphery of the insulator; and
   an external conductor including a plurality of wire rods and securely fixed by the adhesive layer to the outer periphery of the insulator.

2. The coaxial probe pin as claimed in Claim 1, further comprising a sheath member provided to sheath an outer periphery of the external conductor, wherein
   bare end portions of the external conductor are protruding stepwise from the sheath member and exposed on both end sides thereof.

3. The coaxial probe pin as claimed in Claim 1, wherein
   the adhesive layer is made of a material that can melt at a temperature lower than a melting temperature of the insulator.

4. A coaxial cable, comprising:

   an internal conductor;
   an insulator circumferentially provided around the internal conductor;
   an adhesive layer provided in an outer periphery of the insulator; and
   an external conductor including a plurality of wire rods and securely fixed by the adhesive layer to the outer periphery of the insulator.

5. A coaxial probe pin, comprising an insulator having therein an internal conductor serving as an electrically conductive needle, wherein
   an adhesive tape made of a material that can melt at a temperature lower than a melting temperature of the insulator is wound around an outer periphery of the insulator, an external conductor including a plurality of wire rods is wound around an outer periphery of the wound adhesive tape, a heat treatment is performed to a structural body including the external conductor, the adhesive tape, and the insulator at a temperature lower than the melting temperature of the insulator at which the adhesive tape can melt so that the adhesive tape is integrally melted to form an adhesive layer, and the external conductor is securely adhered by the adhesive layer to the outer periphery of the insulator.

6. A coaxial probe pin manufacturing method, comprising:

preparing an insulator having therein an internal conductor serving as an electrically conductive needle;
winding an adhesive tape made of a material that can melt at a temperature lower than a melting temperature of the insulator around an outer periphery of the insulator;
winding an external conductor including a plurality of wire rods around an outer periphery of the wound adhesive tape; and
circumferentially locating an external tape layer around the wound external conductor, a tape made of a material that can melt at a temperature equal to a melting temperature of the adhesive tape being wound around the external tape layer, wherein
a heat treatment is performed to a structural body including the external taper layer, the external conductor, the adhesive tape, and the insulator at a temperature lower than the melting temperature of the insulator at which the adhesive tape and the external tape layer can both melt so that the adhesive tape is integrally melted to form an adhesive layer,
the external conductor is securely adhered by the adhesive layer to the outer periphery of the insulator, and
the external tape layer is melted to be integral with an outer periphery of the external conductor.

7. The coaxial probe pin manufacturing method as claimed in Claim 6, wherein
the method employs so that the wound adhesive tape has a surface with no rises; a single-lap winding in which the adhesive tape is wound around the outer periphery of the insulator in a manner that wound parts are adjacent to one another, or a 1/2-lap winding in which the adhesive tape is wound around the outer periphery of the insulator in a manner that wound parts overlap one another in a given width dimension thereof.

8. The coaxial probe pin manufacturing method as claimed in Claim 6, wherein
the adhesive tape and the external conductor are wound in helical directions reverse to each other.

9. The coaxial probe pin manufacturing method as claimed in Claim 8, wherein
an intersection angle $\alpha$ at which the winding direction of the adhesive tape and the winding direction of the external conductor intersect with each other is set to $80° < \alpha < 100°$.

FIG. 1

F I G. 2

F I G. 3

F I G .  4

## INTERNATIONAL SEARCH REPORT

International application No.

PCT/JP2010/004639

**A. CLASSIFICATION OF SUBJECT MATTER**
*G01R1/067*(2006.01)i, *G01R31/26*(2006.01)i, *H01B11/18*(2006.01)i, *H01B13/016* (2006.01)n

According to International Patent Classification (IPC) or to both national classification and IPC

**B. FIELDS SEARCHED**

Minimum documentation searched (classification system followed by classification symbols)
G01R1/067, G01R31/26, H01B11/18, H01B13/016

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2009-162500 A (Mitsubishi Cable Industries, Ltd.), 23 July 2009 (23.07.2009), paragraph [0015]; fig. 1, 2 & WO 2009/084173 A1 | 1-3,5-9 |
| X Y | Microfilm of the specification and drawings annexed to the request of Japanese Utility Model Application No. 102023/1987(Laid-open No. 007411/1989) (Hitachi Cable, Ltd.), 17 January 1989 (17.01.1989), specification, page 6, lines 8 to 16; fig. 4 (Family: none) | 4 1-3,5-9 |

☒ Further documents are listed in the continuation of Box C. ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| | |
|---|---|
| Date of the actual completion of the international search 17 August, 2010 (17.08.10) | Date of mailing of the international search report 31 August, 2010 (31.08.10) |
| Name and mailing address of the ISA/ Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2010/004639

| C (Continuation). DOCUMENTS CONSIDERED TO BE RELEVANT | | |
|---|---|---|
| Category* | Citation of document, with indication, where appropriate, of the relevant passages | Relevant to claim No. |
| Y | JP 2004-119240 A (Totoku Electric Co., Ltd.),<br>15 April 2004 (15.04.2004),<br>paragraph [0022]<br>(Family: none) | 7 |
| Y | JP 2004-063418 A (Sumitomo Electric Industries, Ltd.),<br>26 February 2004 (26.02.2004),<br>paragraphs [0016], [0017]<br>& US 2006/048966 A1 & WO 2004/013869 A1<br>& CN 1669096 A | 8,9 |
| A | JP 08-069717 A (The Furukawa Electric Co., Ltd.),<br>12 March 1996 (12.03.1996),<br>paragraphs [0018] to [0020]; fig. 1, 2<br>(Family: none) | 1-9 |

Form PCT/ISA/210 (continuation of second sheet) (July 2009)

**EP 2 477 039 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002257849 A